Europäisches Patentamt

European Patent Office

Office européen des brevets

(11) Publication number: **0 206 607**
**A2**

# EUROPEAN PATENT APPLICATION

(21) Application number: 86304366.7

(22) Date of filing: 09.06.86

(51) Int. Cl.⁴: **H03F 1/48 , H03F 3/347**

(30) Priority: 18.06.85 US 746234

(43) Date of publication of application:
30.12.86 Bulletin 86/52

(84) Designated Contracting States:
**DE FR GB**

(71) Applicant: **COMLINEAR CORPORATION
4800 Wheaton Drive
Fort Collins Colorado 80525(US)**

(72) Inventor: **Evans, Scott B.
2303 Eagle Drive
Loveland Colorado 80537(US)**
Inventor: **Smith, Steven O.
6333 East Highway 402
Loveland Colorado 80537(US)**

(74) Representative: **Corin, Christopher John et al
Mathisen Macara & Co. The Coach House 6-8
Swakeleys Road
Ickenham Uxbridge UB10 8BZ(GB)**

(54) Wideband feedback amplifier.

(57) Two amplifier circuits are disclosed, each of which comprises the interconnection of two amplifiers and several resistors, and each of which employs current feedback to achieve a very wide bandwidth characteristic. The 3dB bandwidth and other parameters can be made to be independent of closed loop gain settings over a wide range.

FIG.2

## WIDEBAND FEEDBACK AMPLIFIER

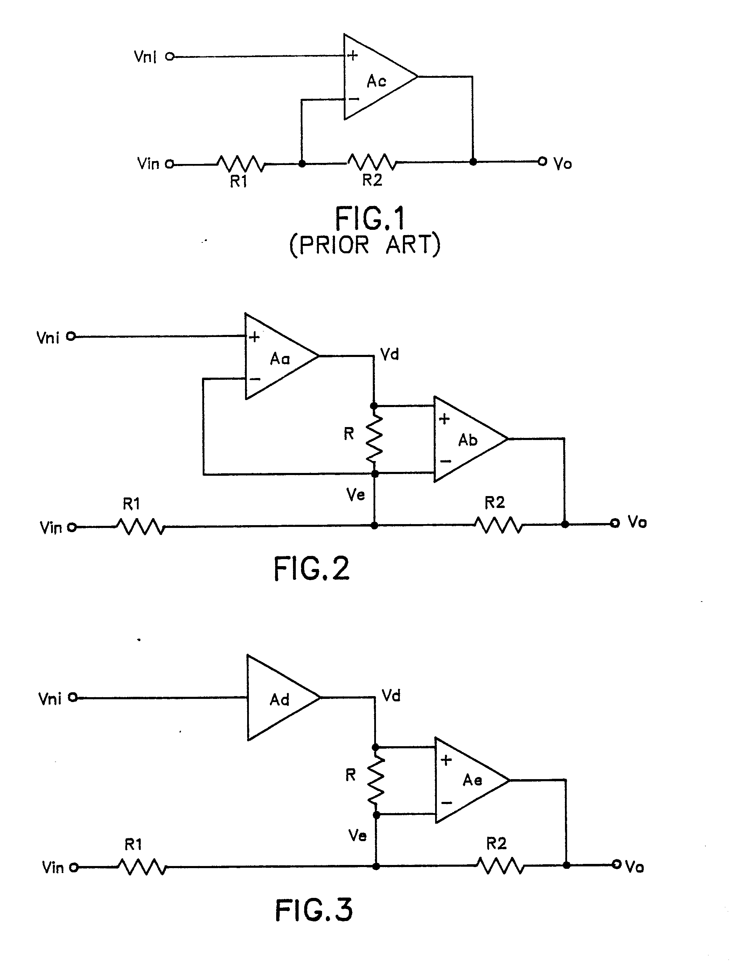

The present invention relates to wideband amplifier circuit configurations. A typical amplifier circuit embodying the teachings of the prior art is shown in Figure 1. This circuit has an inherent shortcoming that limits its usefulness in high frequency applications. This shortcoming results primarily from the use of voltage feedback. The inverting and non-inverting inputs of operational amplifier Ac are high impedance nodes, so the feedback voltage $Ve = VoR1/(R1 + R2)$, assuming $Vin = 0$ for ease of analysis. Then, since $Vo = Ac(Vni -Ve)$, $Vo/Vn1 = G/(1 + G/Ac)$, where $G = 1 + R2/R1$. Substituting for $Ac = Zc/Pc$, where $Zc$ and $Pc$ are complex polynomial expressions of zeros and poles that are functions of frequency, $Vo/Vni = G/(1 + GPc/Zc)$. Thus, $G$ not only scales the magnitude of the closed loop gain as desired, it also multiplies the effect of $Pc$ on the closed loop response. The closed loop pole locations are now a function of $G$. Thus, if $G$ is made large, bandwidth will be inversely proportional to $G$. In practice, high frequency response is limited because of the presence of multiple poles and zeros, and it becomes necessary to compensate the amplifier at each value of $G$ in order to achieve the best response. In many cases, achieving stability and freedom from oscillation severely limits the performance of the amplifier.

The effect of employing current feedback rather than voltage feedback in amplifier configurations is described in US-A-4 358 739 and 4 502 020, and can be explained briefly with reference again to Figure 1. Assuming that only the non-inverting input of operational amplifier Ac has a high input impedance, and that the inverting input is a virtual ground with respect to the non-inverting input independent of the effect of feedback from resistor R2, then it can be shown that $Vo/Vni = G/(1 + R2Pc/Zc)$. Resistor R2 has now replaced G in the denominator of the previous equation. Since resistor R2 can be held constant while resistor R1 changes to give the desired value of G, the frequency response and other related characteristics remain constant. Thus, the amplifier can be designed for optimum performance at any gain without having to compensate as before.

In both voltage and current feedback types of amplifiers described in the preceding two paragraphs, the factor G is equal to -R2/R1 in the case of inverting gain.

The present invention accordingly provides a wideband feedback amplifier comprising first and second inputs, an output and first amplifier means having an input connected to the first amplifier input, characterised in that the amplifier further comprises differential amplifier means having a non-inverting input connected to the output of said first amplifier means, an inverting input, and an output, first resistor means connected between the inverting and non-inverting inputs of said differential amplifier means, second resistor means connected between the second amplifier input and the inverting input of the differential amplifier means, and third resistor means connected between the amplifier output and the inverting input of said differential amplifier means.

Such a wideband amplifier is advantageous in that the two amplifier means are connected in such a way that closed loop current feedback, rather than voltage feedback, dominates the closed loop gain of the wideband amplifier configuration. Such an amplifier achieves a very wide bandwidth characteristic with the 3dB bandwidth and other parameters which can be made independent of the closed loop gain settings over a wide range.

In a preferred embodiment, the first amplifier means comprises a further differential amplifier means having an inverting input which is connected to the inverting input of said differential amplifier means, the first amplifier input being connected to the non-inverting input of the further differential amplifier means.

A prior art amplifier has already been described and two embodiments of a wideband feedback amplifier in accordance with the invention will now be described, by way of example only, with reference to the accompanying diagrammatic drawings, in which

Figure 1 is a functional schematic representation of a prior art differential input amplifier;

Figure 2 is a functional schematic representation of a differential input amplifier constructed in accordance with the present invention; and

Figure 3 is a functional schematic representation of a differential input amplifier constructed in accordance with an alternate embodiment of the present invention.

Referring now to Figure 2, amplifier Aa has a response defined by $Vd = (Vni -Ve)Za/Pa$ where $Za$ and $Pa$ are complex polynomial expressions of zeros and poles that are functions of frequency. Similarly, amplifier Ab has a response defined by $Vo = (Vd -Ve)Zb/Pb$. When these two amplifiers are interconnected as illustrated in Figure 2, the overall input-output transfer function is derived as follows: let $Vin = 0$ to solve for the non-inverting gain (assume that the input impedance of Aa and Ab is infinite); then, solving

$$Vni = VdX + Ve,$$

0 = -VoY + Vd -Ve, and

0 = VoG2 + VdG -Ve(G + G1 + G2) simultaneously, where X = Pa/Za, Y = Pb/Zb, G = 1/R, G1 = 1/R1, and G2 = 1/R2, the result is:

Vo/Vni = (1 + R2/R1)/[1 + Y((1 + X)R2/R + X(1 + R2/R1)) + X].

For inverting gains, only the numerator of this equation changes, and is equal to -R2/R1. To understand the effect of the denominator on frequency response, let X = 0. The denominator equals (1 + R2Pb/RZb). It can be seen that this frequency dependent term is not a function of R1 as it is in a conventional operational amplifier. Therefore, the -3dB bandwidth and other related parameters are not influenced by the closed loop gain setting. In effect, amplifier Aa creates a low inverting input impedance so that Ve is independent of R1 and R2. This prevents an error voltage from existing at Ve, but does cause an error current Iinv = (Vo - Ve)/R2 -(Ve -Vin)/R1 to flow through resistor R. This is a current feedback situation. The voltage IinvR is presented to the inputs of amplifier Ab, and amplifier Ab, resistor R, and resistor R2 then determine the frequency response of the overall amplifier, independent of resistor R1 which does, however, set the closed loop again. In the case where X is not equal to 0 (meaning amplifier Aa is not an ideal amplifier), feedback is a mixture of current and voltage feedback.

The presence of voltage feedback, from the term YX(1 + R2/R1) in the denominator, allows variations from the ideal response to occur. By appropriately choosing the value of the quantity Y/R, frequency response can be controlled within the limitations imposed by the characteristics of X.

Referring now to Figure 3, amplifier Ad has a response defined by Vd = (Vni)Zd/Pd where Zd and Pd are complex polynomial expressions of zeros and poles that are functions of frequency. Similarly, amplifier Ae has a response defined by Vo = (Vd -Ve)Ze/Pe. When these two amplifiers are interconnected as illustrated in Figure 3, the overall input-output transfer function is derived as follows: let Vin = 0 to solve for the non-inverting gain (assume that the input impedance of Ad and Ae is infinite); then, solving

Vni = VdU

0 = -VoW + Vd -Ve, and 0 = VoG2 + VdG -Ve(G + G1 + G2) simultaneously, where U = Pd/Zd, W = Pe/Ze, G = 1/R, G1 = 1/R1, and G2 = 1/R2, the result is

Vo/Vni = (1 + R2/R1)/[U(1 +R2(G + G1))].

For inverting gains, only the numerator of this equation changes, and is equal to -R2/R1. To understand the effect of the denominator on frequency response, let R be much smaller than R1. The denominator equals U(1 + W(1 + R2G)). It can be seen that this frequency dependent term is not a function of R1 as it is in a conventional operational amplifier. Therefore, the -3dB bandwidth and other related parameters are not influenced by the closed loop gain setting. In effect, amplifier Ad creates a low inverting input impedance so that Ve is independent of R1 and R2. This prevents an error voltage from existing at Ve, but does cause an error current Iinv = (Vo -Ve)/R2 -(Ve -Vin)/R1 to flow through resistor R. This is a current feedback situation. The voltage IinvR is presented to the inputs of amplifier Ae, and amplifier Ae, resistor R, and resistor R2 then determine the frequency response of the overall amplifier, independent of resistor R1 which does, however, set the closed loop gain. In the case where resistor R is not significantly smaller than resistor R1, a strong voltage feedback component exists as well.

**Claims**

1. A wideband feedback amplifier comprising:

first and second inputs, an output and first amplifier means (Aa, Ac, Ad) having an input connected to the first amplifier input,

characterised in that,

the amplifier further comprises differential amplifier means (Ab, Ae) having a non-inverting input connected to the output of said first amplifier means -(Aa, Ad), an inverting input, and an output;

first resistor means (R) connected between the inverting and non-inverting inputs of said differential amplifier means (Ab, Ae),

second resistor means (R1) connected between the second amplifier input and the inverting input of the differential amplifier means (Ab, Ae); and

third resistor means (R2) connected between the amplifier output and the inverting input of said differential amplifier means (Ab, Ae).

2. A wideband feedback amplifier according to claim 1,

characterised in that

the first amplifier means comprises a further differential amplifier means (Aa) having an inverting input which is connected to the inverting input of said differential amplifier means, (Ab), the first amplifier input being connected to the non-inverting input of the further differential amplifier means - (Aa).

3. A feedback amplifier comprising:

reference amplifier menas having a reference input forming a first input terminal for receiving a first input signal and having an output, the reference amplifier means being operative for controlling the voltage at a current summing terminal in accordance with the first input signal applied to the first input terminal, said reference amplifier means further comprising current sensing means for developing a differential current sense voltage that is proportional to and in phase with a total current flowing into the current summing terminal;

differential amplifier means having a positive differential input, having a negative differential input, and having an output forming an output terminal of the feedback amplifier, the positive and negative differential inputs of said differential amplifier means being connected to said current sensing means, said differential amplifier means being responsive to a differential current sense voltage developed by the current sensing means for controlling a voltage at said output terminal;

current feedback means connected between said output terminal and said current summing terminal for causing a feedback current proportional to the voltage at said output terminal to flow into said current summing terminal to null said total current flowing into said current summing terminal, within a gain limit imposed by said differential amplifier means; and

resistor means connected between a second input terminal and said current summing terminal for causing a current to flow into said current summing terminal, said current being proportional to a voltage across said resistor means.

4. A feedback amplifier as in claim 3, wherein:

said reference amplifier means comprises a differential amplifier wherein said reference input is a positive reference input, said differential amplifier including a negative reference input of high impedance that is connected to said current summing terminal; and

said current sensing means comprises a current sensing resistor connected between the output of said amplifier means and said current summing terminal.

5. A feedback amplifier as in claim 3, wherein:

said current feedback means comprises a current feedback resistor; and

said positive and negative differential inputs are connected to said current sensing means such that a flow of current into said current summing terminal produces a negative change in voltage at said output terminal.

6. A feedback amplifier as in claim 5, wherein:

said reference amplifier means comprises a differential amplifier wherein said reference input is a positive reference input, said differential amplifier including a negative reference input of high impedance that is connected to said current summing terminal; and

said current sensing means comprises a current sensing resistor connected between the output of said reference amplifier means and said current summing terminal.

7. A feedback amplifier as in claim 3, wherein:

said current sensing means comprises a current sensing resistor connected between the output of said reference amplifier means and said current summing terminal.

8. A feedback amplifier as in claim 7, wherein:

said current feedback means comprises a current feedback resistor; and

said positive and negative differential inputs are connected across said current sensing resistor such that a flow of current into said current summing terminal produces a negative change in voltage at said output terminal

9. A feedback amplifier as in claim 3, wherein:

said reference amplifier means has in-phase unity gain from a voltage at said first input terminal to a voltage at said current summing terminal, in the absence of a current flowing into said current summing terminal and within the limits of a bandwidth characteristic of said reference amplifier means.

10. A feedback amplifier as in claim 9 wherein:

said reference amplifier means comprises a differential amplifier wherein said reference input is a positive reference input, said differential amplifier including a negative reference input of high impedance that is connected to said current summing terminal; and

said current sensing means comprises a current sensing resistor connected between the output of said reference amplifier means and said current summing terminal.

11. A feedback amplifier as in claim 9, wherein:

said current feedback means comprises a current feedback resistor; and

said positive and negative differential inputs are connected to said current sensing means such that a flow of current into said current summing terminal produces a negative change in voltage at said output terminal.

12. A feedback amplifier as in claim 11, wherein:

said reference amplifier means comprises a differential amplifier wherein said reference input is a positive reference input, said differential amplifier including a negative reference input of high impedance that is connected to said current summing terminal; and

said current sensing means comprises a current sensing resistor connected between the output of said reference amplifier means and said current summing terminal.

13. A feedback amplifier as in claim 13, wherein:

said current sensing means comprises a current sensing resistor connected between the output of said reference amplifier means and said current summing terminal.

14. A feedback amplifier as in claim 13, wherein:

said current feedback means comprises a current feedback resistor; and

said positive and negative differential inputs are connected across said current sensing resistor such that a flow of current into said current summing terminal produces a negative change in voltage at said output terminal.

15. A feedback amplifier comprising:

first amplifier means having an input forming a first input terminal for receiving a first input signal, having a first output that is a voltage output, and having a second output;

second amplifier means comprising a differential input amplifier having an inverting input connected to the first output of said first amplifier means, having a non-inverting input connected to the second output of said first amplifier means, and having an output forming an output terminal of the feedback amplifier;

a shunt feedback resistor connected between said output terminal and the first output of said first amplifier means;

a series feedback resistor connected between a second input terminal for receiving a second input signal and the first output of said first amplifier means; and

a current sensing resistor connected between the first and second outputs of said first amplifier means;

said first amplifier means being operative for producing a voltage at said first output exhibiting in-phase unity gain with respect to said input and being further operative for producing a voltage at said second output that is equal to a voltage applied at said input, less the product of the value of said current sensing resistor and a current flowing at said first output.

FIG.1
(PRIOR ART)

FIG.2

FIG.3